Europäisches Patentamt

(19) European Patent Office

Office européen des brevets

(11) Publication number: **0 051 669**
**B1**

## EUROPEAN PATENT SPECIFICATION

(45) Date of publication of patent specification: **24.06.87**

(21) Application number: **81901458.0**

(22) Date of filing: **11.05.81**

(86) International application number:
**PCT/US81/00624**

(87) International publication number:
**WO 81/03399 26.11.81 Gazette 81/28**

(51) Int. Cl.⁴: **H 01 S 3/00, H 01 L 21/265,**
**B 23 K 9/00, H 01 S 3/19**

(54) **SEMICONDUCTOR FABRICATION UTILIZING LASER RADIATION.**

(30) Priority: **16.05.80 US 150460**

(43) Date of publication of application:
**19.05.82 Bulletin 82/20**

(45) Publication of the grant of the patent:
**24.06.87 Bulletin 87/26**

(84) Designated Contracting States:
**DE FR NL**

(56) References cited:
**US-A-3 424 890**
**US-A-4 071 383**
**US-A-4 078 164**
**US-A-4 124 826**
**US-A-4 138 274**
**US-A-4 176 325**
**US-A-4 190 809**
**US-A-4 203 781**
**US-A-4 230 505**
**US-A-4 269 631**

(73) Proprietor: **Western Electric Company,**
**Incorporated**
**222 Broadway**
**New York, NY 10038 (US)**

(72) Inventor: **TIEN, Ping King**
**19 Lisa Drive**
**Chatham, NJ 07928 (US)**

(74) Representative: **Watts, Christopher Malcolm**
**Kelway, Dr. et al**
**Western Electric Company Limited 5,**
**Mornington Road**
**Woodford Green Essex, IG8 0TU (GB)**

Courier Press, Leamington Spa, England.

(56) References cited:

**APPLIED PHYSICS LETTERS, vol. 35, no. 6, September 15, 1979, pages 439-441, American Insitute of Physics, New York, US; R. SALATHE et al.: "Laser-alloyed stripe-geometry DH lasers"**

**IEEE JOURNAL OF QUANTUM ELECTRONICS, vol. QE-16, no. 2, February 1980, pages 197-205, IEEE, New York, US; S. ARAI et al.: "1.11-1.67 mum (100) GaInAsP/InP injection lasers prepared by liquid phase epitaxy"**

**JAPANESE JOURNAL OF APPLIED PHYSICS, vol. 19, suppl. 19-1, 1980, pages 411-414, Proceedings of the 11th Conference (1979 International) on Solid State Devices, Tokyo, 1979, Tokyo, JP; S. ARAI et al.: "1.5-1.6 mum wavelength (100) GaInAsP/InP DH lasers"**

**Applied Physics Letters, 34 (9) 01, May 1979, TANDON et al, "Pulsed-laser annealing of implanted layers in GaAs" B. 597-99 Jour. Applied Physics, 45 (11) November 1974 TSUKADA, "GaAs-Ga1-x A1x As buried heterostructure injection lasers 1-x x 4899-4906 B**

## Description

### Background of the invention

This invention pertains to the field of semiconductor fabrication and more particularly to the application of laser radiation in said fabrication. While not limited thereto, the invention has particular utility in the fabrication of laser devices.

An article entitled "Unstable Horizontal Transverse Modes and their Stabilization with a New Stripe Structure", *IEEE J. Cuant. Elec.*, Vol. QE-13, No. 8, August 1977, pp. 659—661, by K. Kobayashi, R. Lang, H. Yonezu, Y. Matsumoto, T. Shinohara, I. Sakuma, T. Suzuki, and I. Hayashi discloses that the active region of a laser-diode has to form a channel waveguide not more than 5 microns wide for single-mode operation. In fact, as shown in an article entitled "GaAs-Ga$_{1-x}$Al$_x$As Buried-Heterostructure Injection Lasers", *J. Appl. Phys.*, Vol. 45, No. 11, November 1974, pp. 4899—4906 by T. Tsuhoda, the best single-mode AlGaAs/GaAs laser-diode has a mesa type structure which is only about 1 micron wide. The mesa type of structure shown in the Tsukoda article and known by those skilled in the art as a buried structure requires a two-step growth process and is difficult to fabricate.

### Summary of the invention

According to the present invention there is provided a method of fabricating a semiconductor device comprising forming first, second, and third semiconductor layers, the second layer being between and contiguous with and having a different conductivity from the first and third layers, and focusing radiation, with respect to which the second layer is absorptive but the third layer is substantially transparent, from a laser source through the third layer onto a selected area of the second layer so as to induce localized diffusion of dopant impurities to change the conductivity of the second layer in the selected area.

The method can be used to produce a stripe geometry in a semiconductor diode. It will be appreciated that no photolithographic processes are necessary to form the stripe geometry and the method can be applied to many laser-diode structures simultaneously as, for example, when many diodes are to be processed on the same chip in the case of an integrated optic circuit.

### Brief description of the drawing

Fig. 1 shows a laser-diode structure before the application of radiation from a laser source; and

Fig. 2 shows the application of radiation to the laser-diode structure of Fig. 1 and the results thereof.

### Detailed description

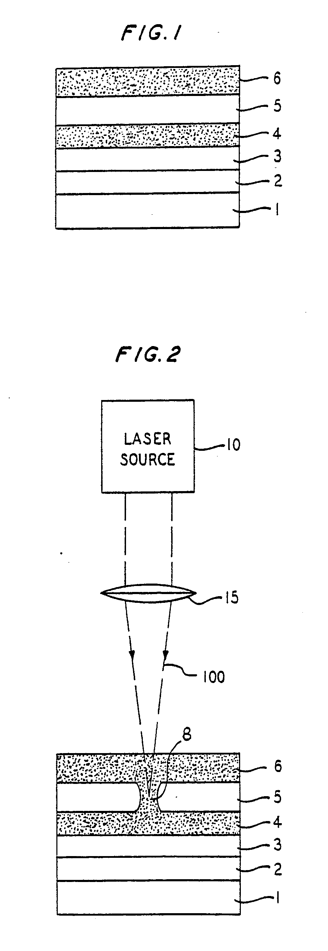

Fig. 1 shows a specific example of a laser-diode structure before annealing. This structure comprises an n-InP substrate layer 1, n-InP buffer layer 2 ($\simeq$10 µm thick),

$$Ga_{.30}In_{.70}As_{.636}P_{.364}$$

active layer 3 ($\simeq$0.25 µm thick) designed for emitting 1.3 micron radiation,

$$p\text{-}Ga_{.171}In_{.829}As_{.373}P_{.627}$$

layer 4 ($\simeq$2 µm thick) using either Cd or Zn as the dopant, 0.3 micron thick moderately doped

$$n\text{-}Ga_{.171}In_{.829}As_{.373}P_{.627}$$

layer 5, and heavily doped p$^+$-InP layer 6 ($\simeq$0.5 µm thick). The n-InP buffer layer 2 serves as one of the confinement layers in the double-heterostructure and is grown to provide a smooth surface for the interface between the substrate 1 and the active layer. The p$^+$-InP cap layer 6 may be replaced by a p$^+$ quaternary cap layer to obtain a low resistance electrical contact.

The structure shown in Fig. 1 may be given by known liquid phase epitaxy processes.

A striped geometry is then formed in the laser structure shown in Fig. 1. Fig. 2 shows the application of laser beam 100 from laser source 10. The laser beam is focused by lens system 15 to a spot size of about 1 micron in diameter. We use the 1.06 micron radiation from a Q-switched Nd:YAG laser, which radiation is highly absorbing in the layers 4 and 5 of

$$Ga_{.171}In_{.829}As_{.373}P_{.627}.$$

We note that caution must be exercised in that the laser beam be applied only in a volume that is typically less than $10^{-8}$ cm$^3$. This is required so that the vapor pressure generated in this volume does not shatter the diode structure. For example, a 60 nanosecond, 2J/cm$^2$ laser pulse is used.

During the application of the laser radiation, the heat generated in layer 5 is sufficient to cause rapid diffusion of p-dopant from the two neighboring p-doped layers 4 and 6 into layer 5 and to convert it into p-type. With the aforementioned laser energy, the p dopants pass entirely through the layer 5 to form a p type channel therethrough at the narrow region heated by the laser beam. If the laser beam is scanned along the structure, an elongated channel or stripe 8 is formed along the length thereof. The resulting structure thus comprises a continuous p type region from the layer 6 through the stripe 8 to the layer 4, the layer 4 forming a p-n junction with the layer 3. On either side of the stripe 8, the original n type layer 5 forms a p-n junction with the layers 4 and 5, thereby restricting current flow from the layer 6 to the layer 4 only through the narrow stripe 8. The narrow current path thus provided by the stripe 8 gives rise to a high current density which, as known, is desirable in laser devices of this type.

In order that the optical energy be absorbed by layer 5, the bandgap wavelength of layer 5 must be larger than the wavelength of the laser. The bandgap wavelengths, $\lambda_g$, of In$_{1-x}$Ga$_x$As$_y$P$_{1-y}$ alloy compounds which are lattice-matched to InP have been measured. They are:

| x | y | $\lambda_g$ (in microns) |
|---|---|---|
| 0.000 | 0.000 | 0.920 |
| 0.083 | 0.155 | 1.005 |
| 0.171 | 0.373 | 1.125 |
| 0.226 | 0.472 | 1.176 |
| 0.250 | 0.531 | 1.225 |
| 0.275 | 0.585 | 1.275 |
| 0.300 | 0.636 | 1.298 |
| 0.305 | 0.658 | 1.343 |
| 0.358 | 0.790 | 1.452 |
| 0.406 | 0.880 | 1.513 |
| 0.475 | 1.000 | 1.650 |

The bandgap wavelength may also be computed from the following formula:

$$\lambda_g \text{ (in microns)} = 1.24/(1.35 - 0.72y + 0.12y^2).$$

Thus for $y=0.373$, $\lambda_g=1.125$ microns, which wavelength is larger than the laser wavelength 1.06 microns. Therefore a compound having this value of y will absorb laser light. On the other hand, InP has $\lambda_g=0.920$ microns, which wavelength is smaller than a 1.06 micron laser wavelength and will therefore be transparent to the laser light. The laser light can only penetrate into the layers 5 and 4 less than 1 micron in combined depth. Thus the laser energy will not reach the active layer 3.

This process may be followed, in a second embodiment of the invention, by the step of applying laser radiation from a second laser. This radiation is absorbed in active layer 3 of the device and anneals that layer. We apply 1.2 micron radiation from an F-center laser, which radiation is absorbing only in the alloy of layer 3,

$$Ga_{0.30}In_{0.70}As_{0.636}P_{0.364},$$

which alloy has a $\lambda_g=1.3$ micron. This step regrows the active layer to provide a better interface for the lasing pn junction.

## Claims

1. A method of fabricating a semiconductor device comprising forming first, second, and third semiconductor layers, the second layer being between, contiguous with and having a different conductivity from the first and third layers, and focusing radiation, with respect to which the second layer is absorptive but the third layer is substantially transparent, from a laser source through the third layer onto a selected area of the second layer so as to induce localized diffusion of dopant impurities to change the conductivity type of the second layer in the selected area.

2. A method as claimed in claim 1 wherein the radiation is scanned so that successive selected areas form a stripe in the second layer.

3. A method as claimed in claim 1 or claim 2 wherein the radiation has a wavelength of 1.06 micrometers and the laser source is a Nd: YAG laser.

4. A method as claimed in claim 3 wherein the radiation is pulsed, having a pulse width of 60 nanoseconds, and is focused to a spot having a 1 micrometer diameter and an energy density per pulse of 2 Joules per square centimeter.

5. A method as claimed in any of the preceding claims wherein the third layer is of $p^+$-type InP.

6. A method as claimed in any of claims 1 to 4 wherein the third layer is of a $p^+$-type quaternary of the form $In_{1-x}Ga_xAs_yP_{1-y}$.

7. A method as claimed in claim 5 or claim 6 wherein the first and second layers are of quaternary compounds of the form $In_{1-x}Ga_xAs_yP_{1-y}$.

8. A method as claimed in any of the preceding claims wherein the first layer is formed on and contiguous with a substantially undoped semiconductor layer whereby a laser-diode structure is formed.

9. A method as claimed in claim 8 wherein, subsequently to the said reversal of conductivity type, radiation from a second laser source to which the substantially undoped layer is absorptive but the first, second and third layers are substantially transparent is applied to anneal the substantially undoped layer.

10. A method as claimed in claim 9 wherein the second laser source is an F-center laser which produces radiation having a wavelength of 1.2 micrometers.

11. A method as claimed in any of claims 8 to 10 wherein the substantially undoped layer is of

$$In_{.70}Ga_{.30}As_{.636}P_{.364}$$

the first and second layers are respectively of p-type and n-type

$$In_{.829}Ga_{.171}As_{.373}P_{.627}$$

and the third layer is of $p^+$-type InP.

## Patentansprüche

1. Verfahren zum Herstellen eines Halbleiterbauelementes, umfassend

— Ausbilden einer ersten, zweiten und dritten Halbleiterschicht, wobei die zweite Schicht zwischen der ersten und dritten Schicht sowie an diese angrenzend gelegen ist und gegenüber diesen unterschiedliche Leitfähigkeit besitzt, und

— Fokussieren der Strahlung einer Laserquelle gegenüber der die zweite Schicht absorbierend, aber die dritte Schicht im wesentlichen transparent ist, durch die dritte Schicht auf ein ausgewähltes Gebiet der zweiten Schicht, um eine lokalisierte Diffusion von Dotierfremdstoffen zur Änderung des Leitungstyps der zweiten Schicht in dem ausgewählten Gebiet zu induzieren.

2. Verfahren wie in Anspruch 1 beansprucht, wobei mit der Strahlung abgetastet wird, so daß aufeinanderfolgende ausgewählte Gebiete einen Streifen in der zweiten Schicht bilden.

3. Verfahren wie in Anspruch 1 oder 2 beansprucht, wobei die Strahlung eine Wellenlänge von 1,06 µm besitzt und die Laserquelle ein Nd:YAG-Laser (neodymdotierter Yttriumaluminiumgranat) ist.

4. Verfahren wie in Anspruch 3 beansprucht, wobei die Strahlung gepulst ist, eine Impulsbreite von 60 Nanosekunden besitzt und auf einen Fleck eines Durchmessers von 1 µm fokussiert ist und eine Energiedichte pro Impuls von 2 Joules pro·cm$^2$ liefert.

5. Verfahren wie in einem der vorstehenden Ansprüche beansprucht, wobei die dritte Schicht p$^+$-leitendes InP ist.

6. Verfahren wie in einem der Ansprüche 1 bis 4 beansprucht, wobei die dritte Schicht eine p$^+$-leitende quaternäre Verbindung der Form In$_{1-x}$Ga$_x$As$_y$P$_{1-y}$ ist.

7. Verfahren wie in Anspruch 5 oder 6 beansprucht, wobei die erste und zweite Schicht quaternäre Verbindungen In$_{1-x}$Ga$_x$As$_y$P$_{1-y}$ sind.

8. Verfahren wie in einem der vorstehenden Ansprüche beansprucht, wobei die erste Schicht auf einer im wesentlichen undotierten Halbleiterschicht sowie an diese angrenzend gebildet wird, wodurch eine Laser-Diodenstruktur gebildet wird.

9. Verfahren wie in Anspruch 8 beansprucht, wobei, auf die besagte Umkehr des Leitungstyps folgend, Strahlung einer zweiten Laserquelle, gegenüber der die im wesentlichen undotierte Schicht absorbierend ist, jedoch die erste, zweite und dritte Schicht im wesentlichen transparent sind, zur Warmbehandlung der im wesentlichen undotierten Schicht zugeführt wird.

10. Verfahren wie in Anspruch 9 beansprucht, wobei die zweite Laserquelle ein F-Zentrum-Laser ist, der eine Strahlung einer Wellenlänge von 1,2 µm erzeugt.

11. Verfahren wie in einem der Ansprüche 8 bis 10 beansprucht, wobei

— die im wesentlichen undotierte Schicht aus

$$In_{0,70}Ga_{0,30}As_{0,636}P_{0,364}$$

ist,

— die erste und zweite Schicht aus p- bzw. n-leitendem

$$In_{0,829}Ga_{0,171}As_{0,373}P_{0,627}$$

sind und

— die dritte Schicht aus p$^+$-leitendem InP ist.

## Revendications

1. Un procédé de fabrication d'un dispositif à semiconducteur dans lequel on forme des première, seconde et troisième couches de semiconducteur, la seconde couche se trouvant entre les première et troisième couches, étant contiguë par rapport à elles et ayant une conductivité différente de la leur, et on focalise sur une zone sélectionnée de la seconde couche, à travers la troisième couche, un rayonnement pouvant d'une source laser et vis-à-vis duquel la seconde couche est absorbante mais la troisième couche est pratiquement transparente, de façon à induire une diffusion localisée d'impuretés de dopage, pour changer le type de conductivité de la seconde couche dans la zone sélectionnée.

2. Un procédé selon la revendication 1, dans lequel on fait accomplir au rayonnement un mouvement de balayage de façon que des zones sélectionnées successives forment un ruban dans la seconde couche.

3. Un procédé selon la revendication 1 ou la revendication 2, dans lequel le rayonnement a une longueur d'onde de 1,06 micromètre et la source laser est un laser de type Nd:YAG.

4. Un procédé selon la revendication 3, dans lequel le rayonnement est produit en régime d'impulsions, avec une largeur d'impulsions de 60 nanosecondes, et il est focalisé en une trace ayant un diamètre de 1 micromètre et une densité d'énergie par impulsion de 2 joules par centimètre carré.

5. Un procédé selon l'une quelconque des revendications précédentes, dans lequel la troisième couche consiste en InP de type p$^+$.

6. Un procédé selon l'une quelconque des revendications 1 à 4, dans lequel la troisième couche est une couche quaternaire de type p$^+$ de la forme In$_{1-x}$Ga$_x$As$_y$P$_{1-y}$.

7. Un procédé selon la revendication 5 ou la revendication 6, dans lequel les première et seconde couches sont des composés quaternaires de la forme In$_{1-x}$Ga$_x$As$_y$P$_{1-y}$.

8. Un procédé selon l'une quelconque des revendications précédentes, dans lequel la première couche est formée sur une couche de semiconducteur qui n'est pratiquement pas dopée, et est contiguë par rapport à elle, ce qui forme une structure de diode laser.

9. Un procédé selon la revendication 8, dans lequel après l'inversion du type de conductivité, on applique un rayonnement provenant d'une seconde source laser vis-à-vis duquel la couche qui n'est pratiquement pas dopée est absorbante, mais les première, seconde et troisième couches sont pratiquement transparentes, pour recuire la couche qui n'est pratiquement pas dopée.

10. Un procédé selon la revendication 9, dans lequel la seconde source laser est un laser à centres F, qui produit un rayonnement ayant une longueur d'onde de 1,2 micromètre.

11. Un procédé selon l'une quelconque des revendications 8 à 10, dans lequel la couche qui n'est pratiquement pas dopée consiste en

$$In_{0,70}Ga_{0,30}As_{0,636}P_{0,364},$$

les première et seconde couches consistent respectivement en

$$In_{0,829}Ga_{0,171}As_{0,373}P_{0.627}$$

de type p et de type n et la troisième couche consiste en InP de type $p^+$.

## FIG.1

## FIG.2